# EUROPEAN PATENT APPLICATION

(11) **EP 3 168 872 A2**
(43) Date of publication of application: **17.05.2017**
(21) Application number: 16198064.4
(22) Date of filing: 10.11.2016
(51) Int. Cl.: H01L 25/065

(54) **SEMICONDUCTOR PACKAGE ASSEMBLEY**

(30) Priority: 12.11.2015 US 201562254244 P; 31.10.2016 US 201615338652
(71) Applicant: MediaTek Inc., Hsin-Chu 300 (TW)
(72) Inventor: Lin, Tzu-Hung, 302 Zhubei City, Hsinchu County (TW); LIU, Nai-Wei, 830 Kaohsiung City (TW); PENG, I-Hsuan, 300 Hsinchu City (TW); HUANG, Wei-Che, 310 Hsinchu County (TW)
(74) Representative: Goddar, Heinz J.

(57) **Abstract**

The invention provides a semiconductor package assembly. The semiconductor package assembly includes a redistribution layer (RDL) structure having a first surface and a second surface opposite to the first substrate. The RDL structure includes a redistribution layer (RDL) contact pad arranged close to the second surface. A passivation layer is disposed on the RDL contact pad. The passivation layer has an opening corresponding to the RDL contact pad such that the RDL contact pad is exposed to the opening. A first distance between a first position of the opening and a central point of the opening is different from a second distance between a second position of the opening and the central point of the opening in a plan view.

## Description

### CROSS REFERENCE TO RELATED APPLICATIONS

This application claims the benefit of U.S. Provisional Application No. 62/254,244 filed November 12, 2015, the entirety of which is incorporated by reference herein.

### BACKGROUND OF THE INVENTION

### Field of the Invention

The present invention relates to a semiconductor package assembly, and in particular to a design of a pad opening of a passivation layer of a redistribution layer (RDL) structure.

### Description of the Related Art

In order to ensure the continued miniaturization and multi-functionality of electric products and communication devices, it is desired that semiconductor packages be small in size, support multi-pin connection, operate at high speeds, and have high functionality. The impact of this will be pressure on semiconductor package fabricators to develop fan-out semiconductor packages. However, the increased amount of input/output connections of a multi-functional chip package may induce thermal electrical problems, for example, problems with heat dissipation, cross talk, signal propagation delay, electromagnetic interference in RF circuits, etc. The thermal electrical problems may affect the reliability and quality of products.

Thus, a novel semiconductor package assembly is desirable.

### BRIEF SUMMARY OF THE INVENTION

A semiconductor package assembly is provided. An exemplary embodiment of a semiconductor package assembly includes a redistribution layer (RDL) structure having a first surface and a second surface opposite to the first substrate. The RDL structure includes a redistribution layer (RDL) contact pad arranged close to the second surface. A passivation layer is disposed on the RDL contact pad. The passivation layer has an opening corresponding to the RDL contact pad such that the RDL contact pad is exposed to the opening. A first distance between a first position of the opening and a central point of the opening is different from a second distance between a second position of the opening and the central point of the opening in a plan view.

Another exemplary embodiment of a semiconductor package assembly includes a redistribution layer (RDL) structure having a first surface and a second surface opposite to the first substrate. The RDL structure includes an RDL contact pad arranged close to the second surface. A passivation layer is disposed on the RDL contact pad. The passivation layer has an opening corresponding to the RDL contact pad such that the RDL contact pad is exposed to the opening. The opening has a first shape and the RDL contact pad has a second shape different from the first shape in a plan view.

Yet another exemplary embodiment of a semiconductor package assembly includes a redistribution layer (RDL) structure having a first surface and a second surface opposite to the first substrate. The RDL structure includes an RDL contact pad arranged close to the second surface. A passivation layer is disposed on the RDL contact pad. The passivation layer has an opening corresponding to the RDL contact pad such that the RDL contact pad is exposed to the opening. The passivation layer has an overlap region overlapping the RDL contact pad. The shape of the inner boundary of the overlap region is different from that of the outer boundary of the overlap region.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1 is a cross-sectional view of a semiconductor package assembly in accordance with some embodiments of the disclosure.
FIG. 2A-2F are plan views showing shapes of openings of the passivation layer and redistribution layer (RDL) contact pads of a redistribution layer (RDL) structure in accordance with some embodiments of the disclosure.
FIG. 3 is a cross-sectional view of a semiconductor package assembly in accordance with some embodiments of the disclosure.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

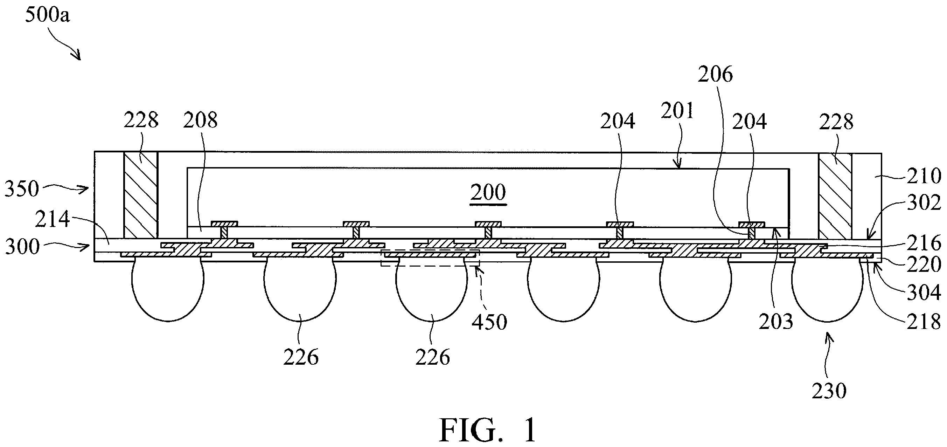

FIG. 1 is a cross-sectional view of a semiconductor package assembly 500a in accordance with some embodiments of the disclosure. In some embodiments, the semiconductor package assembly 500a includes a fan-out wafer-level semiconductor package (FOWLP) 350, for example, a flip-chip semiconductor package. It should be noted that the fan-out wafer-level semiconductor package (FOWLP) 350 used in the semiconductor package assembly 500a is merely an example and is not intended to be limiting the disclosed embodiment.

In some embodiments, the fan-out wafer-level semiconductor package (FOWLP) 350 of the semiconductor package assembly 500a may include a pure system-on-chip (SOC) package or a hybrid system-on-chip (SOC) package (including a dynamic random access memory (DRAM), a power management integrated circuit (PMIC), a flash memory, a global positioning system (GPS) device or a radio frequency (RF) device). The semiconductor package assembly 500a is mounted on the base (not shown), for example a printed circuit board (PCB) formed of polypropylene (PP), by a bonding process.

As shown in FIG. 1, the fan-out wafer-level semiconductor package (FOWLP) 350 of the semiconductor package assembly 500a includes a semiconductor die 200, a molding compound 210, a redistribution layer (RDL) structure 300 and a plurality of conductive structures 226.

As shown in FIG. 1, the semiconductor die 200 has a back-side surface 201 and a front-side surface 203. The semiconductor die 200 is fabricated by a flip-chip technology. The semiconductor die 200 includes die pads 204 disposed on the front-side surface 203 to be electrically connected to the circuitry (not shown) of the semiconductor die 200. In some embodiments, the die pads 204 belong to the uppermost metal layer of the interconnection structure (not shown) of the semiconductor die 200.

As shown in FIG. 1, the fan-out wafer-level semiconductor package (FOWLP) 350 of the semiconductor package assembly 500a includes a dielectric layer 208 is formed covering the front-side surface 203 and portions of the die pads 204 of the semiconductor die 200. The semiconductor package assembly 500a further includes conductive vias 206 positioned corresponding to the die pads 204 and disposed on the front-side surface 203 of the semiconductor die 200. The conductive vias 206 pass through the dielectric layer 208. The conductive vias 206 are in contact with and electrically coupled to the die pads 204 of the semiconductor die 200, respectively.

As shown in FIG. 1, the fan-out wafer-level semiconductor package (FOWLP) 350 of the semiconductor package assembly 500a also includes a molding compound 210 surrounding and covering the semiconductor die 200. The molding compound 210 is in contact with the semiconductor die 200. The molding compound 210 also covers the back-side surface 201 of the semiconductor die 200. In some embodiments, the molding compound 210 may be formed of a nonconductive material, such as an epoxy, a resin, a moldable polymer, or the like. The molding compound 210 may be applied while substantially liquid, and then may be cured through a chemical reaction, such as in an epoxy or resin. In some other embodiments, the molding compound 210 may be an ultraviolet (UV) or thermally cured polymer applied as a gel or malleable solid capable of being disposed around the semiconductor die 200, and then may be cured through a UV or thermal curing process. The molding compound 210 may be cured with a mold.

As shown in FIG. 1, the fan-out wafer-level semiconductor package (FOWLP) 350 of the semiconductor package assembly 500a also includes a redistribution layer (RDL) structure 300 is disposed on front-side surface 203 of the semiconductor die 200. The RDL structure 300 has a first surface 302 and a second surface 304 opposite to the first substrate 302. The first surface 302 of the RDL structure 300 may be in contact with the molding compound 210. Also, the first surface 302 of the RDL structure 300 is close to the front-side surface 203 of the semiconductor die 200. In some embodiments, the RDL structure 300 includes conductive traces 216, intermetal dielectric (IMD) layers 214, RDL contact pads 218 and a passivation layer 220.

In some embodiments, one or more conductive traces 216 are disposed in one or more intermetal dielectric (IMD) layers 214 of the RDL structure 300. The conductive traces 216 close to the first surface 302 are electrically coupled to the die pads 204 of the semiconductor die 200 through the conductive vias 206 disposed therebetween. Also, the conductive vias 206 and the dielectric layer 208 are in contact with the RDL structure 300. Moreover, the conductive traces 216 are in contact with and electrically connected to corresponding RDL contact pads 218 close to the second surface 304 of the RDL structure 300.

As shown in FIG. 1, the conductive traces 216 of the RDL structure 300 may be designed to fan out from one or more of the die pads 204 of the semiconductor die 200 to provide electrical connections between the semiconductor die 200 and the corresponding RDL contact pads 218. Therefore, the RDL contact pads 218 may have a larger pitch than the die pads 204 of the semiconductor die 200, which may be suitable for a ball grid array or another package mounting system. However, it should be noted that the number of conductive traces 216, the number of IMD layers 214 and the number of RDL contact pads 218 shown in FIG. 1 is only an example and is not a limitation to the present invention.

In some embodiments, as shown in FIG. 1, the passivation layer 220 of the RDL structure 300 covers the IMD layers 214, which is close to the second surface 304 of the RDL structure 300. In some embodiments, the passivation layer 220 serves as a topmost layer of the RDL structure 300. That is to say, a top surface of the passivation layer 220 serves as the second surface 304 of the RDL structure 300. The passivation layer 220 has openings 230 corresponding to the RDL contact pads 218. Therefore, portions of the RDL contact pads 218 are respectively exposed to the corresponding openings 230 of the passivation layer 220. The passivation layer 220 may be composed of a material that is the same as or different from that of IMD layers 214. For example, the passivation layer 220 may be formed of an epoxy, a solder mask, an inorganic material (e.g., silicon nitride (SiN_{X}), silicon oxide (SiO_{X})), an organic polymer base material, or the like.

In some other embodiments, as shown in FIG. 1, the fan-out wafer-level semiconductor package (FOWLP) 350 of the semiconductor package assembly 500a optionally includes a plurality of vias 228 passing through the molding compound 210. The plurality of vias 228 is disposed on the first surface 302 of the RDL structure 300. The plurality of vias 228 is electrically connected to the plurality of conductive traces 216 of the RDL structure 300. Also, the semiconductor die 200 may be surrounded by the plurality of vias 228. In some embodiments, the plurality of vias 228 may comprise through package vias (TPVs) formed of copper. The plurality of vias 228 may serve as electrical connections to transmit input/output (I/O), ground or power signals from another semiconductor package (not shown) vertically stacked on the semiconductor package assembly 500a to form a three-dimensional (3D) semiconductor package.

As shown in FIG. 1, the fan-out wafer-level semiconductor package (FOWLP) 350 of the semiconductor package assembly 500a also includes conductive structures 226 disposed on the second surface 304 of the RDL structure 316, which is away from the semiconductor die 200. The conductive structures 226 are formed passing through the openings 230 of the passivation layer 220. Also, the conductive structures 226 are in contact with and electrically connected to the corresponding RDL contact pads 218, respectively. It should be noted that no UBM (under bump metallurgy) layer is formed between the RDL contact pads 218 and the corresponding conductive structures 226. In some embodiments, the conductive structures 226 may comprise a conductive bump structure such as a copper bump or a solder bump structure, a conductive pillar structure, a conductive wire structure, or a conductive paste structure.

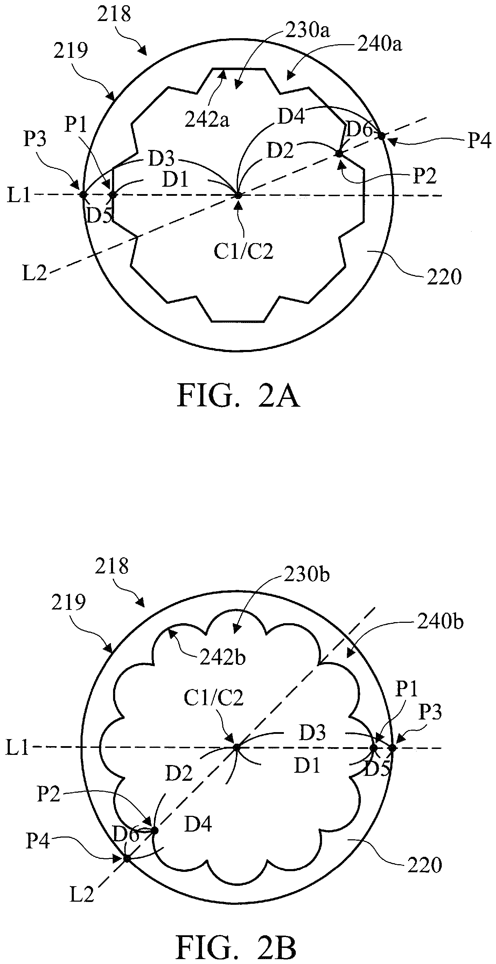

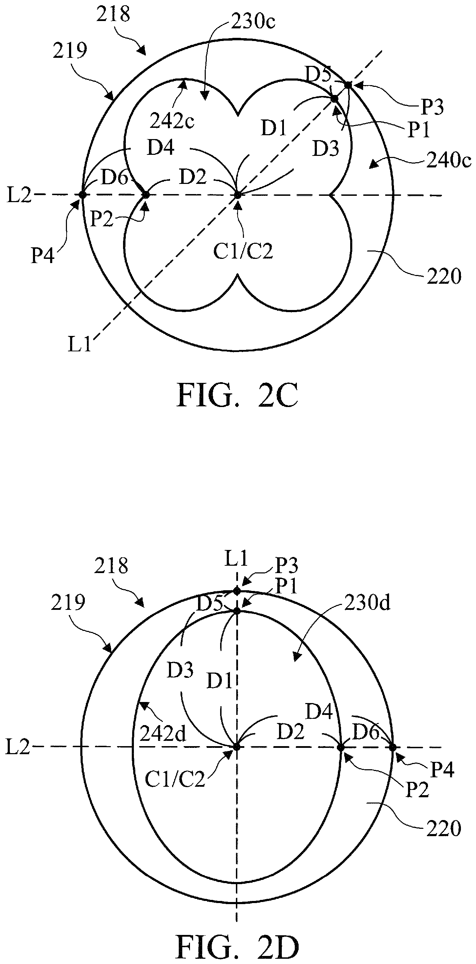

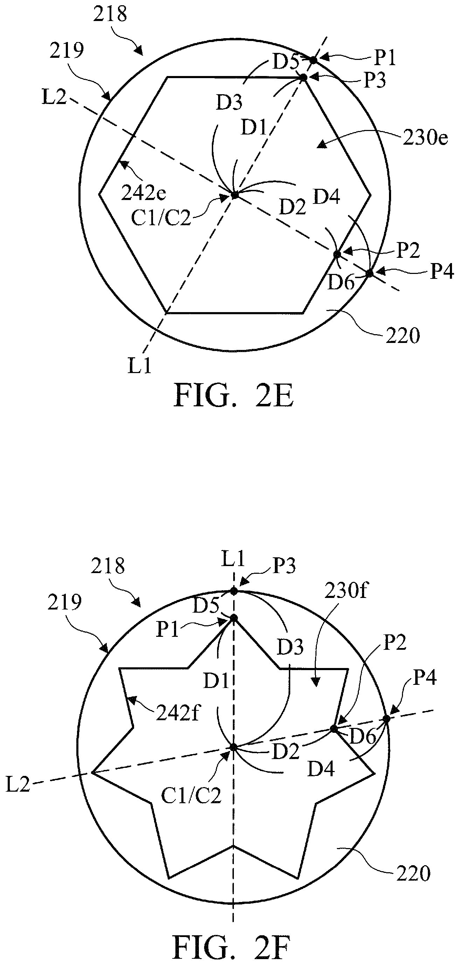

FIGS. 2A-2F are plan views of an area 450 in FIG. 1. FIG. 2A-2F showing openings 230a-230f of the passivation layer 220 and redistribution layer (RDL) contact pads of a redistribution layer (RDL) structure in accordance with some embodiments of the disclosure. In FIGS. 2A-2F, the conductive structure 226 is omitted. In some embodiments, the opening of the passivation layer 220 is surrounded by a boundary 219 of the RDL contact pad 218. The RDL contact pad 218 has a circular shape. In some embodiments, the openings 230a-230f of the passivation layer 220 may be designed to have a shape that is different from the shape of the corresponding RDL contact pad 218 in the plan views shown in FIGS. 2A-2F. The shape of the openings 230a-230f of the passivation layer 220 is a non-circular shape. For example, the shape of the openings 230a-230f of the passivation layer 220 comprises a petal-shape (e.g., the openings 230a-230c shown in FIGS. 2A-2C), an oval shape (e.g., the opening 230d shown in FIG. 2D), a polygonal shape (e.g., the opening 230e shown in FIG. 2E) or a star-like shape (e.g., the opening 230f shown in FIG. 2F). In some embodiments, the petal-shaped openings 230a-230c may comprise a plurality of petal-shaped portions (e.g., at least four petal-shaped portions) extending outwardly from the central point C1 of the openings 230a-230c shown in FIGS. 2A-2C. In some embodiments, the petal-shaped portions may be designed to have one or more vertices (i.e. one or more angular points of a polygon) (e.g., the opening 230a shown in FIG. 2A) or to have a rounded edge (e.g., the openings 230b-230c shown in FIGS. 2B-2C).

In some embodiments, the shapes of the openings 230a-230f of the passivation layer 220 may be designed to have rotational symmetry. The openings 230a-230f of the passivation layer 220 can be respectively rotated around the central point C1 of the openings 230a-230f, in the plan views shown in FIGS. 2A-2F.

Because the openings 230a-230f of the passivation layer 220 have a non-circular shape, the first distance D1 between the central point C1 and the first position P1 of the opening of the passivation layer 220 is different from the second distance D2 between the central point C1 and the second position P2 of the opening of the passivation layer 220. As shown in FIG. 2A, for example, the first distance D1 between the first position P1 and the central point C1 of the opening 230a of the passivation layer 220 is different from the second distance D2 between the second position P2 and the central point C1 of the opening 230a of the passivation layer 220. Similarly, the first distance D1 between the first position P1 and the central point C1 of the opening 230b of the passivation layer 220 is different from the second distance D2 between the second position P2 and the central point C1 of the opening 230b of the passivation layer 220 as shown in FIG. 2B. The first distance D1 between the first position P1 and the central point C1 of the opening 230c of the passivation layer 220 is different from the second distance D2 between the second position P2 and the central point C1 of the opening 230c of the passivation layer 220 as shown in FIG. 2C. The first distance D1 between the first position P1 and the central point C1 of the opening 230d of the passivation layer 220 is different from the second distance D2 between the second position P2 and the central point C1 of the opening 230d of the passivation layer 220 as shown in FIG. 2D. The first distance D1 between the first position P1 and the central point C1 of the opening 230e of the passivation layer 220 is different from the second distance D2 between the second position P2 and the central point C1 of the opening 230e of the passivation layer 220 as shown in FIG. 2E. The first distance D1 between the first position P1 and the central point C1 of the opening 230f of the passivation layer 220 is different from the second distance D2 between the second position P2 and the central point C1 of the opening 230f of the passivation layer 220 as shown in FIG. 2F.

In some embodiments, the first position P1 of the opening of the passivation layer 220 is defined as the position that is located most outward from the central point C1 of the opening, as shown in FIGS. 2A-2F. The second position P2 of the opening of the passivation layer 220 is defined as the position that is located most inward from the first position P1, as shown in FIGS. 2A-2F. In some embodiments, the first distance D1 is greater than the second distance D2 by a range of about 15-30 µm. In some embodiments, the difference between the first distance D1 and the second distance D2 is about 2%-7% of the first distance D1.

Compared with the non-circular shaped openings 230a-230f of the passivation layer 220, the RDL contact pad 218 has a circular-shaped boundary 219. Therefore, a third distance D3 between a third position P3 of a boundary 219 of the RDL contact pad 218 and the central point C2 of the RDL contact pad 218 is the same as a fourth distance D4 between a fourth position P4 of the boundary 219 of the RDL contact pad 218 and the central point C2 of the RDL contact pad 218, as shown in FIGS. 2A-2F. In some embodiments, the third distance D3 and the fourth distance D4 are both greater than the first distance D1. Also, the third distance D3 and the fourth distance D4 are both greater than the second distance D2.

It should be noted that the first position P1 and the third position P3 are located on a first straight-line L1 passing through the central point C1 of the opening of the passivation layer 220 and the central point C2 of the RDL contact pad 218. Also, the second position P2 and the fourth position P4 are located on a second straight-line L2 passing through the central point C1 of the opening of the passivation layer 220 and a central point C2 of the RDL contact pad 218 in some embodiments as shown in FIGS. 2A-2F. Also, the central point C1 of the opening of the passivation layer 220 is designed overlapping the central point C2 of the RDL contact pad 218.

Because the openings 230a-230f of the passivation layer 220 have a non-circular shape, the fifth distance D5 between the first position P1 of the opening of the passivation layer 220 and the third position P3 of the boundary 219 of the RDL contact pad 218 along the first straight-line L1 is different from the sixth distance D6 between the second position P2 of the opening of the passivation layer 220 and the fourth position P4 of the boundary 219 of the RDL contact pad 218 along the second straight-line L2, as shown in FIGS. 2A-2F. In some embodiments, the sixth distance D6 is designed to be greater than the fifth distance D5 by a range of about 15-30 µm. In some embodiments, the difference between the fifth distance D5 and the sixth distance D6 is about 2%-7% of the first distance D1.

Additionally, the passivation layer 220 has an overlap region, for example, overlap regions 240a-240f, overlapping the RDL contact pad 218 as shown in FIGS. 2A-2F. Each of the overlap regions 240a-240f has an inner boundary (e.g. inner boundaries 242a-242f) and an outer boundary (fully overlaps with the boundary 219 of the RDL contact pad 218). In some embodiments, the shapes of the inner boundaries 242a-242f of the overlap regions 240a-240f are different from those of the corresponding outer boundaries (i.e. the boundary 219) of the overlap regions 240a-240f in the plan views shown in FIGS. 2A-2F. In some embodiments, the shapes of the inner boundaries 242a-242f of the overlap regions 240a-240f may be a wave-shape, a petal-shape, an oval shape, a polygonal shape or a star-like shape in the plan view. Also, the overlap regions 240a-240f may have at least two radial widths, which are respectively the same as the fifth distance D5 and the sixth distance D6.

In some embodiments, the design of the non-circular openings in the passivation layer can be used in a package-on-package (POP) semiconductor package assembly.

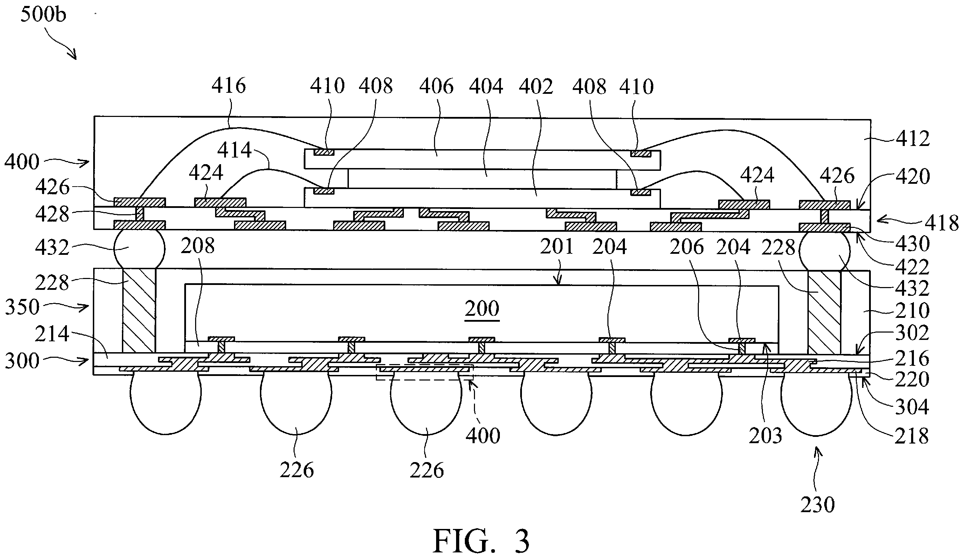

FIG. 3 is a cross-sectional view of a semiconductor package assembly 500b in accordance with some embodiments of the disclosure. Elements of the embodiments hereinafter, that are the same or similar as those previously described with reference to FIG. 1, are not repeated for brevity.

The differences between the semiconductor package assembly 500a (FIG. 1) and the semiconductor package assembly 500b is that the semiconductor package assembly 500b includes a flip-chip semiconductor package, and a dynamic random access memory (DRAM) package 400 stacked thereon vertically stacked thereon. The semiconductor package assembly 500b may also serve a package-on-package (POP) semiconductor package assembly. It should be noted that the fan-out wafer-level semiconductor package (FOWLP) 350 and the dynamic random access memory (DRAM) package 400 used in the semiconductor package assembly 500b is merely an example and is not intended to be limiting the disclosed embodiment.

As shown in FIG. 3, the DRAM package 400 is stacked on the FOWLP 350 by a bonding process. In some embodiments, the DRAM package 400 includes a low-power double data rate DRAM (LPDDR DRAM) package following the pin assignment rule (such as JEDEC LPDDR I/O Memory specification). Alternatively, the DRAM package 400 may include a Wide I/O DRAM package. In one embodiment, the DRAM package 400 includes a body 418 and at least one DRAM die, for example, three DRAM dies 402, 404 and 406, stacked thereon. The body 418 has a die-attach surface 420 and a bump-attach surface 422 opposite to the die-attach surface 420. In this embodiment, as shown in FIG. 3, there are three DRAM dies 402, 404 and 406 mounted on the die-attach surface 420 of the body 418. The DRAM die 404 is stacked on the DRAM die 402 through a paste (not shown), and the DRAM die 406 is stacked on the DRAM die 404 through a paste (not shown). The DRAM dies 402, 404 and 406 may be coupled to the body 418 by bonding wires, for example bonding wires 414 and 416. However, the number of stacked DRAM devices is not limited to the disclosed embodiment. Alternatively, the three DRAM dies 402, 404 and 406 as shown in FIG. 3 can be arranged side by side. Therefore, the DRAM dies 402, 404 and 406 are mounted on die-attach surface 420 of the body 418 by paste. The body 418 may comprise circuitry 428 and metal pads 424 and 426 and 430. The metal pads 424 and 426 are disposed on the top of the circuitry 428 close to the die-attach surface 420. The metal pads 430 are disposed on the bottom of the circuitry 428 close to the bump-attach surface 430. The circuitry 428 of the DRAM package 400 is interconnected with the conductive traces 216 of the RDL structure 300 via a plurality of conductive structures 432 disposed on the bump-attach surface 422 of the body 418. In some embodiments, the conductive structures 432 may comprise a conductive bump structure such as a copper bump or a solder bump structure, a conductive pillar structure, a conductive wire structure, or a conductive paste structure. In some embodiments, the DRAM package 400 is coupled to the conductive traces 216 of the RDL structure 300 by the vias 228 passing through the molding compound 210 between the DRAM package 400 and the RDL structure 300 of the FOWLP 350.

In one embodiment, as shown in FIG. 3, the DRAM package 400 further includes a molding material 412 covering the die-attach surface 420 of the body 418, encapsulating the DRAM dies 402, 404 and 406, the bonding wires 414 and 416.

Embodiments provide a semiconductor package assembly, for example, a fan-out wafer-level semiconductor package (FOWLP). The semiconductor package assembly has a redistribution layer (RDL) structure to redistribute and fan-out one or more of the die pads with a small pitch. Also, the topmost passivation layer of the RDL structure is designed to have non-circular openings such that portions of the corresponding RDL contact pads are exposed to the openings to facilitate the corresponding conductive structure landing thereon. The openings of the passivation layer are designed to have a non-circular shape to improve the reliability window of the semiconductor package assembly. For example, the non-circular opening of the passivation layer helps to increase the area of the overlap region of the passivation layer, which overlaps the corresponding RDL contact pad. Therefore, the adhesion between the RDL contact pad and the corresponding conductive structure (e.g., a solder bump structure), which is in contact with the RDL contact pad without the UBM layer formed therebetween, is improved. The stress occurring at the corner of the RDL contact pad can be reduced. Compared with the conventional circular-shaped RDL contact pad opening of the passivation layer, the non-circular opening of the passivation layer has a longer perimeter so that failure due to ball (or a solder bump structure) fatigue can be avoided. Also, the problem of cracks forming in the passivation layer can be avoided.

While the invention has been described by way of example and in terms of the preferred embodiments, it is to be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package assembly, comprising:
a redistribution layer (RDL) structure having a first surface and a second surface opposite to the first substrate, wherein the RDL structure comprises:
a redistribution layer (RDL) contact pad arranged close to the second surface; and
a passivation layer disposed on the RDL contact pad, the passivation layer has an opening corresponding to the RDL contact pad such that the RDL contact pad is exposed to the opening,
wherein:
a first distance between a first position of the opening and a central point of the opening is different from a second distance between a second position of the opening and the central point of the opening in a plan view.

2. The semiconductor package assembly as claimed in claim 1, wherein the first distance is between a first position on a boundary of the opening and a center of the opening and the second distance is between a second position on the boundary of the opening and the center of the opening in the plan view.

3. The semiconductor package assembly as claimed in claim 1 or 2, wherein a third distance between a third position of a boundary of the RDL contact pad and the central point of the RDL contact pad is the same as a fourth distance between a fourth position of the boundary of the RDL contact pad and the central point of the RDL contact pad.

4. The semiconductor package assembly as claimed in claim 3, wherein the first position and the third position are located on a first straight-line passing through the central point of the opening and that of the RDL contact pad.

5. The semiconductor package assembly as claimed in claim 3 or 4, wherein the second position and the fourth position are located on a second straight-line passing through the central point of the opening and that of the RDL contact pad.

6. The semiconductor package assembly as claimed in one of claims 3 to 5, wherein the fifth distance between the first position and the third position along the first straight-line is different from the sixth distance between the second position and the fourth position along the second straight-line.

7. The semiconductor package assembly as claimed in one of the preceding claims, wherein the opening has a first shape and the RDL contact pad has a second shape different from the first shape in the plan view.

8. The semiconductor package assembly as claimed in claim 7, wherein the first shape is a non-circular shape.

9. The semiconductor package assembly as claimed in claim 7 or 8, wherein the first shape has rotational symmetry.

10. The semiconductor package assembly as claimed in one of claims 7 to 9, wherein the first shape comprises a petal-shape, an oval shape, a polygonal shape or a star-like shape.

11. The semiconductor package assembly as claimed in one of the preceding claims, wherein the passivation layer has an overlap region overlapping the RDL contact pad, wherein a shape of an inner boundary of the overlap region is different from that of an outer boundary of the overlap region.

12. The semiconductor package assembly as claimed in one of the preceding claims, wherein the opening is surrounded by a boundary of the RDL contact pad.

13. The semiconductor package assembly as claimed in one of the preceding claims, further comprising:
a semiconductor die disposed on the first surface of the RDL structure and electrically coupled to the RDL structure;
a molding compound surrounding the semiconductor die, being in contact with the first surface of the RDL structure and the semiconductor die; and
a conductive structure electrically connected to the RDL contact pad.

14. The semiconductor package assembly as claimed in claim 13, wherein the conductive structure is in contact with the RDL contact pad and/or is disposed on the second surface of the RDL structure and/or passes through the opening.
